# EUROPÄISCHE PATENTSCHRIFT

(11) **EP 1 141 959 B1**
(45) Veröffentlichungstag und Bekanntmachung des Hinweises auf die Patenterteilung: **03.07.2002**
(21) Anmeldenummer: 00904822.4
(22) Anmeldetag: 03.01.2000
(51) Int. Cl.: G11C 7/06, G11C 7/10, G11C 11/22

(54) **INTEGRIERTER SPEICHER**
INTEGRATED MEMORY
MEMOIRE INTEGREE

(30) Priorität: 12.01.1999 DE 19900802
(43) Veröffentlichungstag der Anmeldung: 10.10.2001
(73) Patentinhaber: Infineon Technologies AG, 81669 München (DE)
(72) Erfinder: BRAUN, Georg, D-80339 München (DE); HÖNIGSCHMID, Heinz, D-82319 Starnberg (DE); BÖHM, Thomas, D-85604 Zorneding (DE); RÖHR, Thomas, D-85609 Aschheim (DE); MANYOKI, Zoltan, D-81739 München (DE)
(74) Vertreter: Müller - Hoffmann & Partner
(86) Internationale Anmeldenummer: DE0000025
(87) Internationale Veröffentlichungsnummer: WO0042612

(56) Entgegenhaltungen:
- US-A- 5 511 031
- US-A- 5 953 275
- PATENT ABSTRACTS OF JAPAN vol. 017, no. 585 (P-1632), 25. Oktober 1993 (1993-10-25) & JP 05 166373 A (HITACHI LTD), 2. Juli 1993 (1993-07-02)

## Beschreibung

Die Erfindung betrifft einen integrierten Speicher.

In der US 5,517,446 A ist ein integrierter Speicher in Form eines ferroelektrischen Speichers (FRAM oder FeRAM) beschrieben, bei dem die Speicherzellen an Bitleitungen angeschlossen sind, die jeweils zu Bitleitungspaaren zusammengefaßt sind. Jedes Bitleitungspaar ist über einen Leseverstärker mit einem Datenleitungspaar verbunden. Bei einem Schreibzugriff werden Daten über das Datenleitungspaar und den Leseverstärker sowie das Bitleitungspaar in eine der Speicherzellen übertragen. Bei einem Lesezugriff erfolgt die Datenübertragung in umgekehrter Richtung aus einer der Speicherzellen über das Bitleitungspaar zum Leseverstärker, der ein sich auf dem Bitleitungspaar einstellendes Differenzsignal verstärkt auf das Datenleitungspaar weitergibt. Um Energie zu sparen, werden in der US 5,517,446 A immer nur diejenigen Leseverstärker aktiviert, über die beim aktuellen Schreib- oder Lesezugriff eine Datenübertragung erfolgen muß. Aus dem gleichen Grund erfolgt eine Vorladung der Bitleitungen ebenfalls nur in dem Fall, in dem über sie Daten übertragen werden sollen. Dies wird erreicht, indem die Aktivierung des Leseverstärkers sowie das Vorladen des Bitleitungspaares in Abhängigkeit vom selben Signal erfolgt, mit dem der jeweils ausgewählte Leseverstärker mit dem zugehörigen Datenleitungspaar verbunden wird. Dieses Signal wird von einem Spaltendecoder aus Spaltenadressen decodiert. Ein vom Spaltendecoder decodiertes Ausgangssignal, das dieser in seiner letzten Decoderstufe erzeugt, dient also sowohl zum Verbinden der Bitleitungen mit den Datenleitungen, zur Aktivierung des Leseverstärkers sowie zur Aktivierung der Vorladung des Bitleitungspaares.

In H. Fujisawa: "The Charge-Share Modified (CSM) Precharge-Level Architecture for High-Speed and Low-Power Ferroelectric Memory" in: IEEE Journal of Solid-State Circuits, Vol. 32, No. 5, Mai 1997, Seite 655ff. ist ein FRAM beschrieben, bei dem jeweils eine größere Anzahl Bitleitungen demselben Leseverstärker zugeordnet sind. Diese Bitleitungen sind über einen Multiplexer mit dem Leseverstärker verbunden.

Der Erfindung liegt die Aufgabe zugrunde, einen integrierten Speicher mit mehreren Bitleitungen pro Leseverstärker anzugeben, bei dem eine Beeinflussung von über den Leseverstärker und die Bitleitungen erfolgenden Schreib- bzw. Lesezugriffen auf Speicherzellen des Speichers auf einfache Weise realisiert ist.

Diese Aufgabe wird mit einem integrierten Speicher gemäß Patentanspruch 1 gelöst. Vorteilhafte Aus- und Weiterbildungen der Erfindung sind Gegenstand abhängiger Ansprüche.

Der erfindungsgemäße integrierte Speicher weist m>1 Bitleitungen auf, die über je ein Schaltelement mit einem Eingang eines Leseverstärkers verbunden sind, zum Übertragen von Daten aus bzw. in mit den Bitleitungen verbundenen Speicherzellen. Weiterhin weist der Speicher eine Schaltungseinheit zur Beeinflussung von über den Leseverstärker und die Bitleitungen erfolgenden Schreib- bzw. Lesezugriffen auf die Speicherzellen auf, die einen Aktivierungseingang aufweist, über den sie in einen aktivierten Zustand versetzbar ist. Der Speicher hat einen Spaltendecoder mit einer ersten und m zweiten Decoderstufen, wobei die erste Decoderstufe Eingänge zur Zuführung von Adreßsignalen und einen Ausgang aufweist, und wobei die zweiten Decoderstufen jeweils einen Eingang, der mit dem Ausgang der ersten Decoderstufe verbunden ist, wenigstens einen weiteren Eingang zur Zuführung eines weiteren Adreßsignals und einen Ausgang aufweisen. Die Ausgänge der zweiten Decoderstufen sind mit einem Steuereingang je eines der Schaltelemente verbunden. Der Ausgang der ersten Decoderstufe ist mit dem Aktivierungseingang der Schaltungseinheit verbunden.

Bei der Erfindung erfolgt die Beeinflussung eines Schreibbzw. Lesezugriffes für alle mit dem Leseverstärker verbundenen Bitleitungen mittels der Schaltungseinheit über ein gemeinsames Signal, nämlich dasjenige, was am Ausgang der ersten Decoderstufe erzeugt wird. Zwar sind hierarchische Decoder, die mehrere hintereinander geschaltete Decoderstufen aufweisen, wie sie auch die Erfindung vorsieht, grundsätzlich bekannt. Allerdings werden üblicherweise nur die Ausgänge der letzten Decoderstufe zur Beeinflussung nachgeschalteter Schaltungseinheiten verwendet. Dies gilt beispielsweise auch für die eingangs erwähnte US 5,517,446 A. Bei der Erfindung sind die Steuereingänge der Schaltelemente mit den Ausgängen der zweiten Decoderstufen verbunden. Zusätzlich wird bei der Erfindung in unüblicher Weise das Ausgangssignal der ersten, den zweiten Decoderstufen vorgelagerten Decoderstufe zur Ansteuerung der Schaltungseinheit verwendet. Als Folge dessen erfolgt über das Ausgangssignal der ersten Decoderstufe jedesmal eine Aktivierung der Schaltungseinheit, wenn über den Ausgang einer beliebigen der zweiten Decoderstufen eines der ersten Schaltelemente leitend geschaltet wird..

Nach einer ersten Ausführungsform der Erfindung aktiviert die Schaltungseinheit im aktivierten Zustand den Leseverstärker. Dies kann beispielsweise durch Verbinden des Leseverstärkers mit einem Versorgungspotential erfolgen.

Nach einer anderen Ausführungsform verbindet die Schaltungseinheit im aktivierten Zustand den Leseverstärker mit einer Datenleitung, die zum Übertragen von aus den Speicherzellen ausgelesenen und vom Leseverstärker verstärkten Daten nach außerhalb des Speichers dient.

Nach einer weiteren Ausführungsform der Erfindung lädt die Schaltungseinheit im aktivierten Zustand den Eingang des Leseverstärkers auf ein bestimmtes Potential vor.

Die Erfindung wird im folgenden anhand der Figuren näher erläutert, die Ausführungsbeispiele der Erfindung zeigen. Es zeigen:
- Figur 1: einen Ausschnitt eines ersten Ausführungsbeispiels des erfindungsgemäßen Speichers,
- Figur 2: ein Ausführungsbeispiel eines hierarchischen Decoders des integrierten Speichers aus Figur 1,
- Figur 3: ein Detail des Decoders aus Figur 2,
- Figur 4: ein zweites Ausführungsbeispiel des integrierten Speichers und
- Figur 5: ein Detail einer weiteren Ausführungsform des integrierten Speichers mit einer Vorladeeinheit.

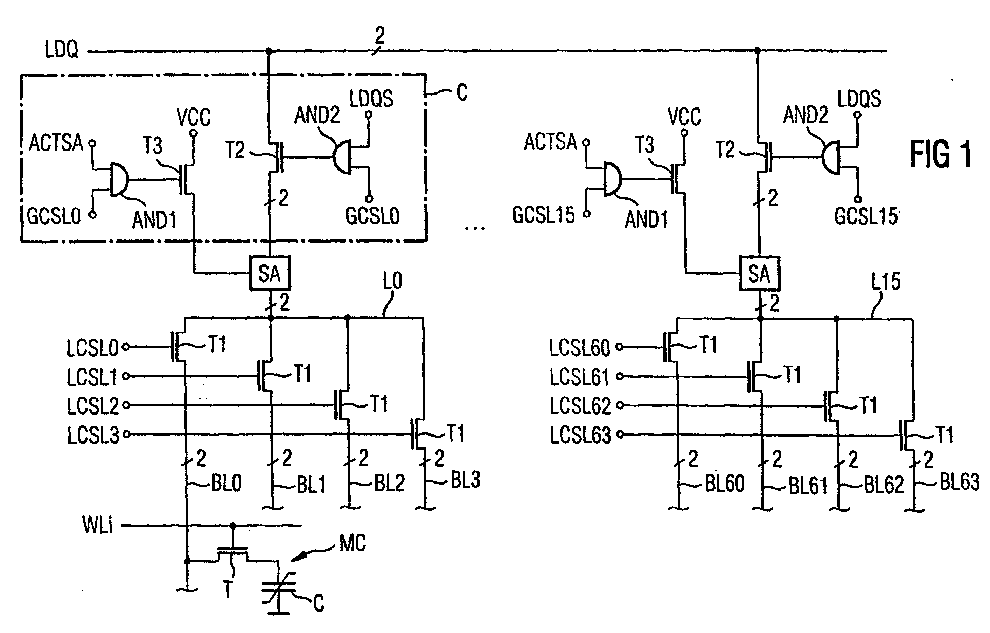

Figur 1 zeigt ein erstes Ausführungsbeispiel des erfindungsgemäßen integrierten Speichers. Es handelt sich beispielhaft um einen ferroelektrischen Speicher (FRAM). Die Erfindung eignet sich jedoch auch für andere Speicher, wie beispielsweise DRAMs. Der Speicher weist eine große Anzahl von Leseverstärkern SA auf, von denen in Figur 1 nur zwei dargestellt sind. Weitere Leseverstärker sind durch drei Punkte in der Figur 1 angedeutet. Jeder Leseverstärker SA ist einerseits über ein Leitungspaar L0 und je ein erstes Schaltelement T1 in Form eines n-Kanal-Transistors mit den zwei Bitleitungen je eines Bitleitungspaares BLi verbunden. Von den Leitungspaaren Li und den Bitleitungspaaren BLi sind in Figur 1 nur jeweils eine Leitung bzw. eine Bitleitung dargestellt. Dabei ist jeder Bitleitung eines Bitleitungspaares in Wirklichkeit ein eigenes erstes Schaltelement T1 zugeordnet. Jede der Bitleitungen BLi ist mit einer großen Anzahl von Speicherzellen MC verbunden, die jeweils einen Auswahltransistor T und einen Speicherkondensator C mit einem ferroelektrischen Dielektrikum aufweisen. Hierbei handelt es sich um allgemein bekannte Speicherzellen vom 1-Transistor-1-Kondensator-Typ. Ein Steueranschluß des Auswahltransistors T jeder Speicherzelle MC ist mit einer Wortleitung WLi verbunden.

Jeder Leseverstärker SA ist andererseits über zwei zweite Schaltelemente T2 in Form von n-Kanal-Transistoren mit den Leitungen eines Datenleitungspaares LDQ verbunden. Bei einem Schreibzugriff werden Daten über das Datenleitungspaar LDQ, einen der Leseverstärker SA, das zugehörige Leitungspaar Li sowie eines der mit diesem Leitungspaar Li verbundenen Bitleitungspaare BLi zu einer der Speicherzellen MC übertragen, und dort gespeichert. Bei einem Lesezugriff erfolgt die Datenübertragung in umgekehrter Richtung. Auf welche der Speicherzellen MC bei einem Schreib- oder Lesezugriff zugegriffen wird, wird durch Adressierung der Wortleitungen WLi und der Bitleitungen BLi bestimmt. In Abhängigkeit dieser Adressierung wird nur eines der Bitleitungspaare BLi gleichzeitig über seine ersten Schaltelemente T1 mit dem zugehörigen Leseverstärker SA verbunden. Außerdem wird jeweils nur einer der Leseverstärker SA über seine zweiten Schaltelemente T2 mit dem Datenleitungspaar LDQ verbunden. Bei den Leseverstärkern SA handelt es sich um bei DRAMs bzw. FRAMs übliche differentielle Verstärker. Die Erfindung ist jedoch auch auf Speicher anwendbar, die einfache, nicht-differentielle Leseverstärker aufweisen, und bei denen die Datenübertragung nicht über Bitleitungspaare, sondern über nur jeweils eine einzelne Bitleitung erfolgt.

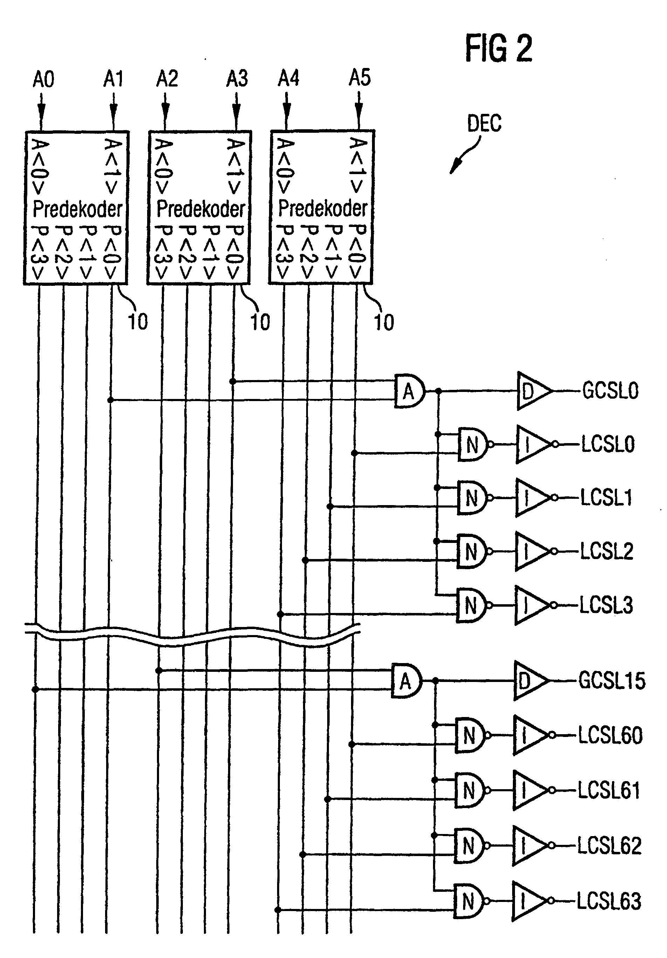

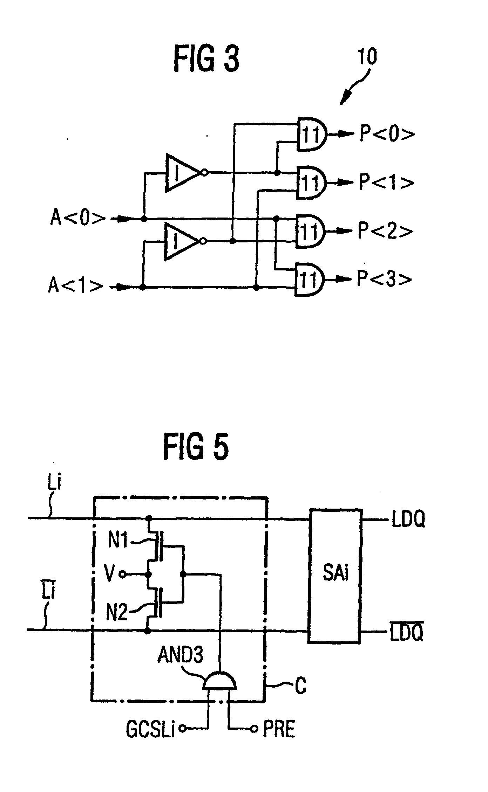

Figur 2 zeigt einen Spaltendecoder DEC für Spaltenadressen Ai. Die Spaltenadressen Ai werden jeweils paarweise je einem Vordecoder 10 zugeführt, der an seinen Ausgängen vier vordecodierte Adreßsignale P<i> erzeugt. Der Aufbau eines der Vordecoder 10 aus Figur 2 ist in Figur 3 dargestellt. Er weist vier UND-Gatter 11 auf, an deren Ausgängen die vordecodierten Adressen P<i> erzeugt werden. Den jeweils zwei Eingängen der UND-Gatter 11 wird eine jeweils unterschiedliche Kombination der invertierten oder nicht-invertierten Eingangssignale A<i> des Vordecoders 10 zugeführt. Die invertierte Version jedes dieser Eingangssignale wird mittels je eines Inverters I erzeugt.

Der Decoder DEC in Figur 2 weist, den Vordecodern 10 nachgeschaltet, eine Vielzahl von ersten Decoderstufen A in Form von UND-Gattern und, wiederum den ersten Decoderstufen jeweils nachgeschaltet, jeweils vier zweite Decoderstufen N in Form von NAND-Gattern mit jeweils einem nachgeschalteten Inverter I auf. Jede erste Decoderstufe A, von denen in Figur 2 lediglich zwei dargestellt sind, weist zwei Eingänge auf, denen jeweils unterschiedliche Kombinationen der vordecodierten Adressen P<i> zugeführt werden. Jede zweite Decoderstufe N weist zwei Eingänge auf, von denen jeweils einer mit dem Ausgang der zugehörigen ersten Decoderstufe A verbunden ist, während dem anderen Eingang jeweils eine weitere der vordecodierten Adressen zugeführt wird.

Beim in Figur 2 dargestellten Spaltendecoder DEC erzeugen die ersten Decoderstufen A über einen nachgeschalteten Treiber D an einem Ausgang globale Spaltenauswahlsignale GCSLi. Die zweiten Decoderstufen N erzeugen an ihren Ausgängen jeweils lokale Spaltenauswahlsignale LCSLi. Es kann nur jeweils eines der lokalen Spaltenauswahlsignale LCSLi einen hohen Pegel aufweisen, dessen zugehörige erste Decoderstufe A an ihrem Ausgang ebenfalls einen hohen Pegel aufweist.

Figur 1 ist zu entnehmen, daß die Ausgänge der zweiten Decoderstufen N mit Steuereingängen der ersten Schaltelemente T1 verbunden sind. Über die lokalen Spaltenauswahlsignale LCSLi erfolgt also die Selektion eines der Bitleitungspaare BLi. Somit ist gewährleistet, daß gleichzeitig immer nur eines der Bitleitungspaare BLi mit dem zugehörigen Leseverstärker SA verbunden ist. Figur 1 ist auch zu entnehmen, daß die Ausgänge der ersten Decoderstufen A aus Figur 2 mit einem ersten Eingang je eines ersten UND-Gatters AND1 verbunden sind, die jeweils einem der Leseverstärker SA zugeordnet sind. Ein zweiter Eingang aller ersten UND-Gatter AND1 ist mit einem Aktivierungssignal ACTSA verbunden, über das die Bewertung durch einen der Leseverstärker SA gestartet wird. Ein Ausgang jedes ersten UND-Gatters AND1 ist mit jeweils einem Steuereingang eines n-Kanal-Transistors T3 verbunden, der über seine zu steuernde Strecke den zugehörigen Leseverstärker SA mit einem Versorgungspotential VCC verbindet. Da zum selben Zeitpunkt nur jeweils eines der globalen Spaltenauswahlsignale GCSLi einen hohen Pegel aufweist, wird bei Aktivierung des Aktivierungssignals ACTSA nur einer der Leseverstärker SA mit dem Versorgungspotential VCC verbunden. Somit ist nur dieser Leseverstärker SA anschließend aktiviert und kann bei einem Lesezugriff auf dem Leitungspaar Li anliegende Signale verstärkt auf das Datenleitungspaar LDQ weitergeben bzw. bei einem Schreibzugriff vom Datenleitungspaar LDQ Daten zum Leitungspaar Li übertragen.

Figur 1 zeigt auch zweite UND-Gatter AND2, deren Ausgang mit je einem Steuereingang eines der zweiten Schaltelemente T2 verbunden ist. Ein erster Eingang der zweiten UND-Gatter AND2 ist mit einem Steuersignal LDQS verbunden, das für alle zweiten Schaltelemente T2 gleich ist. Ein zweiter Eingang jedes zweiten UND-Gatters AND2 ist mit je einem der Ausgänge der ersten Decoderstufen A des Spaltendecoders DEC in Figur 2 verbunden, so daß den zweiten UND-Gattern AND2 jeweils verschiedene globale Spaltenauswahlsignale GCSLi zugeführt werden. Über letztere erfolgt beim in Figur 1 gezeigten Speicher also auch die Auswahl, welcher der Leseverstärker SA mit dem Datenleitungspaar LDQ verbunden wird, sofern das Steuersignal LDQS einen hohen Pegel aufweist.

Beim in Figur 1 dargestellten Speicher erfolgt eine Beeinflussung von Schreib- bzw. Lesezugriffen auf die Speicherzellen MC, also auf zweierlei Art über die globalen Spaltenauswahlsignale GCSLi: Erstens wird bei einer positiven Flanke des Aktivierungssignals ACTSA nur derjenige Leseverstärker SA mit dem Versorgungspotential VCC verbunden, dessen globales Spaltenauswahlsignal GCSLi einen hohen Pegel aufweist. Außerdem wird auch nur dieser Leseverstärker SA über seine zweiten Schaltelemente T2, ebenfalls in Abhängigkeit seines globalen Spaltenauswahlsignals GCSLi, bei einer positiven Flanke des Steuersignals LDQS mit dem Datenleitungspaar LDQ verbunden. Bei anderen Ausführungsformen der Erfindung ist es selbstverständlich auch möglich, daß nur eine dieser beiden Beeinflussungsarten vorgesehen ist.

Bei anderen Ausführungsformen der Erfindung ist es darüber hinaus möglich, daß alternativ oder zusätzlich zu den soeben beschriebenen beiden Beeinflussungsarten die Schreib- bzw. Lesezugriffe auf eine dritte Art durch die Ausgangssignale der ersten Decoderstufen A aus Figur 2 beeinflußt werden. Diese dritte Möglichkeit ist in Figur 5 gezeigt. Sie zeigt einen der Leseverstärker SAi, der einerseits mit seinem Leitungspaar Li, /Li und andererseits mit dem Datenleitungspaar LDQ, /LDQ verbunden ist. Die beiden Leitungen Li, /Li sind über die steuerbaren Strecken eines ersten n-Kanal-Transistors N1 und eines zweiten n-Kanal-Transistors N2 miteinander verbunden. Der gemeinsame Kanalanschluß der beiden Transistoren N1, N2 ist mit einem festen Potential V verbunden. Dieses dient zu einem Vorladen der Leitungen Li, /Li. Die Steueranschlüsse der beiden Transistoren N1, N2 sind miteinander und mit dem Ausgang eines dritten UND-Gatters AND3 verbunden. Der eine Eingang des dritten UND-Gatters AND3 ist mit einem Vorladesignal PRE und der andere Eingang des dritten UND-Gatters AND3 ist mit dem dem Leseverstärker SAi zugeordneten globalen Spaltenauswahlsignal GCSLi verbunden. Jedem Leseverstärker SAi ist eine derartige Vorladeschaltung zugeordnet. Das Vorladesignal PRE ist für alle Vorladeschaltungen gleich. Die Vorladung erfolgt jedoch nur für dasjenige Leitungspaar Li, /Li, für das das zugehörige globale Spaltenauswahlsignal GCSLi einen hohen Pegel aufweist.

In den Figuren 1 und 5 sind die Schaltungseinheiten C gestrichelt eingetragen, die einer Beeinflussung der Schreib- bzw.

Lesezugriffe in Abhängigkeit der Ausgangssignale der ersten Decoderstufen A dienen. In Figur 5 handelt es sich bei der Schaltungseinheit C um die Vorladeschaltung.

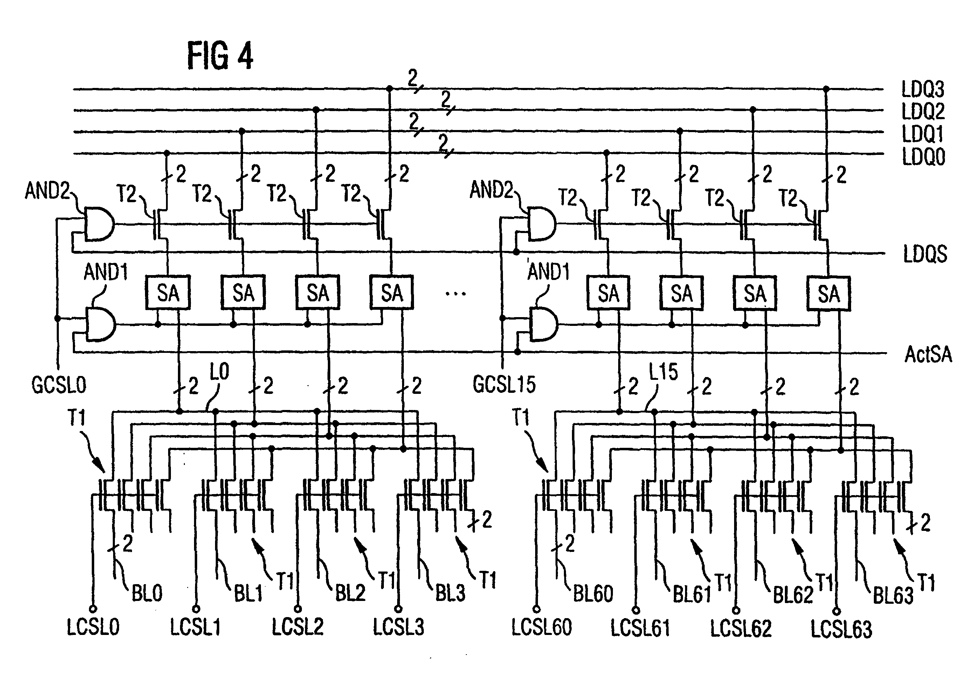

Figur 4 ist ein weiteres Ausführungsbeispiel des integrierten Speichers zu entnehmen, der sich von demjenigen in Figur 1 darin unterscheidet, daß statt eines einzelnen Datenleitungspaares LDQ vier Datenleitungspaare LDQi vorhanden sind, so daß gleichzeitig vier Leseverstärker SA, die mit je einem der Datenleitungspaare LDQi über entsprechende zweite Schaltelemente T2 verbunden sind, gleichzeitig zur Übertragung von Daten dienen können. Der Spaltendecoder DEC für dieses Ausführungsbeispiel entspricht demjenigen aus Figur 2. Jedes lokale Spaltenauswahlsignal LCSLi in Figur 4, das eines der Ausgangssignale der zweiten Decoderstufen N aus Figur 2 ist, ist für jeden der gleichzeitig aktivierbaren Leseverstärker SA mit je einem diesem zugeordneten ersten Schaltelement T1 verbunden. Somit werden über die lokalen Spaltenauswahlsignalen LCSLi gleichzeitig jeweils vier Bitleitungspaare BLi mit jedem der vier gleichzeitig aktivierbaren Leseverstärker SA verbunden. Dabei werden die Leseverstärker SA erst aktiviert, wenn sowohl das Aktivierungssignal ACTSA, das für alle Leseverstärker gleich ist, als auch das entsprechende globale Spaltenauswahlsignal GCSLi einen hohen Pegel aufweist. Außerdem werden die vier Leseverstärker SA nur dann über die zweiten Schaltelemente T2 mit den Datenleitungspaaren LDQi verbunden, wenn sowohl das Steuersignal LDQS, das für alle Leseverstärker gleich ist, als auch das den jeweiligen Leseverstärkern SA zugeordnete globale Spaltenauswahlsignal GCSLi einen hohen Pegel aufweist. Damit immer vier Leseverstärker gleichzeitig aktiviert und mit den Datenleitungspaaren LDQi verbunden werden, ist beim integrierten Speicher gemäß Figur 4 jeweils diesen vier Leseverstärkern SA ein gemeinsames globales Spaltenauswahlsignal GCSLi zugeordnet.

Bei den geschilderten Ausführungsbeispielen erfolgt immer zunächst die Decodierung der Spaltenadressen durch den Spaltendecoder DEC und die Erzeugung der lokalen LCSLi und globalen GCSLi Spaltenauswahisignale, bevor das Aktivierungssignal ACTSA, das Steuersignal LDQS und das Vorladesignal PRE mit einer positiven Flanke aktiviert werden. Dadurch ist gewährleistet, daß die Spaltenauswahlsignale LCSLi, GCSLi bereits vollständig decodiert vorliegen und die Leseverstärker SA bereits mit den entsprechenden Bitleitungspaaren BLi verbunden sind, bevor die Leitungspaare Li vorgeladen werden (wodurch automatisch das entsprechende Bitleitungspaar mit diesen vorgeladen wird), anschließend der Leseverstärker für eine Bewertung des sich nach einer Aktivierung einer der Wortleitungen WLi einstellenden Differenzsignals auf dem Leitungspaar Li aktiviert wird und schließlich die Verbindung zwischen den Leseverstärkern und den Datenleitungspaaren hergestellt wird. Dadurch, daß für alle Leseverstärker SA das Aktivierungssignal ACTSA, das Vorladesignal PRE und das Steuersignal LDQS gleich ist, erfolgen die durch sie ausgelösten Prozesse für alle Schreib-/Lesezugriffe in definierter Weise.

## Patentansprüche

1. Integrierter Speicher
- mit m>1 Bitleitungen (BL0..3), die über je ein Schaltelement (T1) mit einem Eingang eines Leseverstärkers (SA) verbunden sind, zum Übertragen von Daten aus bzw. in mit den Bitleitungen verbundenen Speicherzellen (MC),
- mit einer Schaltungseinheit (C) zur Beeinflussung von über den Leseverstärker (SA) und die Bitleitungen (BL0..3) erfolgenden Schreib- bzw. Lesevorgängen, die einen Aktivierungseingang aufweist, über den sie in einen aktivierten Zustand versetzbar ist,
- mit einem Spaltendecoder (DEC) mit einer ersten (A) und m zweiten (N) Decoderstufen,
- dessen erste Decoderstufe (A) Eingänge zur Zuführung von Adreßsignalen und einen Ausgang (GCSL0) aufweist,
- dessen zweite Decoderstufen (N) jeweils einen Eingang, der mit dem Ausgang (GCSL0) der ersten Decoderstufe (A) verbunden ist, wenigstens einen weiteren Eingang zur Zuführung eines weiteren Adreßsignals und einen Ausgang (LCSL0..3) aufweisen,
- bei dem die Ausgänge (LCSL0..3) der zweiten Decoderstufen (N) mit einem Steuereingang je eines der Schaltelemente (T1) verbunden sind,
- und bei dem der Ausgang (GCSL0) der ersten Decoderstufe (A) mit dem Aktivierungseingang der Schaltungseinheit (C) verbunden ist.

2. Integrierter Speicher nach Anspruch 1,
dessen Schaltungseinheit (C) im aktivierten Zustand den Leseverstärker (SA) aktiviert.

3. Integrierter Speicher nach Anspruch 1,
dessen Schaltungseinheit (C) im aktivierten Zustand den Leseverstärker (SA) mit einer Datenleitung (LDQ0) verbindet, die zum Übertragen von aus den Speicherzellen (MC) ausgelesenen und vom Leseverstärker (SA) verstärkten Daten nach außerhalb des Speichers dient.

4. Integrierter Speicher nach Anspruch 1,
dessen Schaltungseinheit (C) im aktivierten Zustand den Eingang des Leseverstärkers auf ein bestimmtes Potential (V) vorlädt.

## Claims

1. Integrated memory
- having m>1 bit lines (BL0..3) which are connected via a respective switching element (T1) to an input of a sense amplifier (SA), for transferring data from or to memory cells (MC) connected to the bit lines,
- having a circuit unit (C) for influencing write or read operations taking place via the sense amplifier (SA) and the bit lines (BL0..3), which has an activation input via which it can be put into an activated state,
- having a column decoder (DEC) having a first (A) and m second (N) decoder stages,
- whose first decoder stage (A) has inputs for feeding in address signals and an output (GCSL0),
- whose second decoder stages (N) each have an input which is connected to the output (GCSL0) of the first decoder stage (A), at least one further. input for feeding in a further address signal, and an output (LCSL0..3),
- in which the outputs (LCSL0..3) of the second decoder stages (N) are connected to a control input of a respective one of the switching elements (T1),
- and in which the output (GCSL0) of the first decoder stage (A) is connected to the activation input of the circuit unit (C).

2. Integrated memory according to Claim 1,
whose circuit unit (C) activates the sense amplifier (SA) in the activated state.

3. Integrated memory according to Claim 1,
whose circuit unit (C) connects the sense amplifier (SA) to a data line (LDQ0) in the activated state, said data line serving for transferring, to a point outside the memory, data that have been read from the memory cells (MC) and amplified by the sense amplifier (SA).

4. Integrated memory according to Claim 1,
whose circuit unit (C) precharges the input of the sense amplifier to a specific potential (V) in the activated state.

## Revendications

1. Mémoire intégrée
- comprenant m>1 lignes (BL0..3) de bits, qui sont reliées par respectivement un élément (T1) de circuit à une entrée d'un amplificateur (SA) de lecture, pour faire sortir ou entrer des données dans des cellules (MC) de mémoire reliées aux lignes de bits,
- comprenant une unité (C) de circuit destinée à influencer des opérations d'écriture ou de lecture s'effectuant par l'intermédiaire des amplificateurs (SA) de lecture et des lignes (BLO..3) de bits, qui comporte une entrée d'activation par laquelle elle peut être mise dans un état activé,
- comprenant un décodeur (DEC) de colonnes ayant un premier étage (A) et m deuxièmes étages (N) de décodeur,
- dont le premier étage (A) de décodeur comporte des entrées pour envoyer des signaux d'adresse et une sortie (GCSL0) et
- dont les deuxièmes étages (N) de décodeur comportent respectivement une entrée qui est reliée à la sortie (GCSL0) du premier étage (A) de décodeur, au moins une autre entrée pour envoyer un autre signal d'adresse et une sortie (LCSL0..3),
- dans laquelle les sorties (LCSL0..3) des deuxièmes étages (L) de décodeur sont reliées à une entrée de commande de respectivement l'un des éléments (T1) de commutation,
- et dans laquelle la sortie (GCSL0) du premier étage (A) de décodeur est reliée à l'entrée d'activation de l'unité (C) de circuit.

2. Mémoire intégrée suivant la revendication 1, dont l'unité (C) de circuit est activée lorsque l'amplificateur (SA) de lecture est à l'état activé.

3. Mémoire intégrée suivant la revendication 1, dont l'unité (C) de circuit relie à l'état activé l'amplificateur (SA) de lecture à une ligne (LDQ0) de données, qui sert à transmettre à l'extérieur de la mémoire des données lues dans les cellules (MC) de mémoire et amplifiées par l'amplificateur (SA) de lecture.

4. Mémoire intégrée suivant la revendication 1, dont l'unité (C) de circuit met à l'état activé l'entrée de l'amplificateur de lecture à un potentiel (V) déterminé.
